# EUROPÄISCHE PATENTANMELDUNG

(11) **EP 2 253 962 A1**
(43) Veröffentlichungstag der Anmeldung: **24.11.2010**
(21) Anmeldenummer: 10005176.2
(22) Anmeldetag: 18.05.2010
(51) Int. Cl.: G01R 11/04, H02B 1/03

(54) **Klemmendeckel für einen Elektrizitätszähler**

(30) Priorität: 18.05.2009 DE 102009022645
(71) Anmelder: EMH metering GmbH & Co. KG, 19243 Wittenburg (DE)
(72) Erfinder: Kramer, Jochen, 21376 Eyendorf (DE)
(74) Vertreter: Hauck Patent- und Rechtsanwälte

(57) **Zusammenfassung**

Klemmendeckel (10) zur Abdeckung von Anschlussklemmen eines Elektrizitätszählers, wobei der Klemmendeckel zur Befestigung (16) eines Zusatzgeräts an dem Klemmendeckel vorbereitet ist und eine Kabeldurchführung (50) aufweist, durch die Verbindungskabel zur Verbindung des Zusatzgeräts mit Anschlussklemmen (18) des Elektrizitätszähler (20) hindurchführbar sind, **dadurch gekennzeichnet, dass** die Kabeldurchführung im an einem Elektrizitätszähler befindlichen Zustand des Klemmendeckels im Bereich der Anschlussklemmen angeordnet ist, so dass die Anschlussklemmen zur Verbindung mit den Verbindungskabeln durch die Kabeldurchführung zugänglich sind, ohne den Klemmendeckel von dem Elektrizitätszähler zu entfernen.

## Beschreibung

Die Erfindung betrifft einen Klemmendeckel zur Abdeckung von Anschlussklemmen eines Elektrizitätszählers, wobei der Klemmendeckel zur Befestigung eines Zusatzgeräts an dem Klemmendeckel vorbereitet ist und eine Kabeldurchführung aufweist, durch die Verbindungskabel zur Verbindung des Zusatzgeräts mit Anschlussklemmen des Elektrizitätszählers hindurchführbar sind.

Derartige Klemmendeckel sind von der Installation herkömmlicher Wechselstrom- oder Drehstromzähler in Dreipunktmontage bekannt, die insbesondere in Haushaltszählerschränke eingebaut werden. Die Anschlusskabel werden an Anschlussklemmen befestigt, die an der Unterseite des Elektrizitätszählers angeordnet sind. Um eine unbeabsichtigte Berührung spannungsführender Teile zu verhindern, werden diese Anschlussklemmen von einem Klemmendeckel abgedeckt. Der Klemmendeckel wird in der Regel verplombt. Durch die Verplombung werden eine unbemerkte Manipulation an den Anschlussklemmen des Elektrizitätszählers und eine betrügerische Stromentnahme verhindert, sodass die Interessen des Messstellenbetreibers gewahrt werden.

Herkömmliche Klemmendeckel, die zur Montage eines Zusatzgeräts auf dem Klemmendeckel vorbereitet sind, weisen eine Kabeldurchführung zur Hindurchführung von Verbindungskabeln auf. Die Verbindungskabel werden vor der Montage des Klemmendeckels durch diese Kabeldurchführung hindurchgeführt und mit den zugehörigen Anschlussklemmen des Elektrizitätszählers verbunden. Anschließend wird der Klemmendeckel nahe dem Elektrizitätszähler befestigt.

Zusätzlich zu dem Elektrizitätszähler können auch Zusatzgeräte für die Kommunikation, Steuerung und/oder zur Aufzeichnung im Zählerschrank montiert werden. Aus Platzgründen werden die Zusatzgeräte vorteilhaft gemäß der Norm DIN 43860 Teil 2 auf dem Klemmendeckel montiert. Die Klemmendeckel sind nach DIN 43857 Teil 5 ausgerührt und weisen spezielle Bohrungen zur Montage des Zusatzgeräts auf. In der Regel wird die Sicherung des Zusatzgeräts vor Berührung und Manipulation durch eine Plombe an dem Zusatzgerät erreicht, während die Plombierschrauben des Klemmendeckels durch das Zusatzgerät abgedeckt werden. Elektronische Haushaltszähler einer neueren Bauform werden nicht über Anschlussklemmen, sondern mit einer speziellen Stecktechnik mit den Hausanschlussleitungen verbunden. Einzelheiten der Stecktechnik sind in dem FNN-Lastenheft (vormals VDN-Lastenheft) für elektronische Haushaltszähler definiert. Die Steckverbindung befindet sich an der Rückseite des Haushaltszählers und bedarf keiner gesonderten Abdeckung. Auf einen Klemmendeckel kann daher verzichtet werden. Berühr- und Manipulationsschutz wird auch bei dieser neueren Bauform elektronischer Haushaltszähler durch Versiegelung erreicht. Dabei verhindert eine verplombte Schraube oder ein Bolzen ein Verschieben der Steckverbindung.

Weil der Platzbedarf dieser neuartigen Zähler deutlich geringer ist als derjenige herkömmlicher Zähler mit Dreipunktmontage, passen Zusatzgeräte problemlos neben den Zähler in den Zählerschrank oder an einen sonstigen zur Montage des Zählers vorgesehenen Platz. Die für diesen Einsatzzweck vorgesehenen Zusatzgeräte sind häufig kompakter aufgebaut, als die für die Montage auf einem herkömmlichen Klemmendeckel bestimmten. Durch den technischen Fortschritt haben Sie außerdem häufig eine verbesserte oder erweiterte Funktionalität und sind preiswerter als die Zusatzgeräte herkömmlicher Bauweise. Beispielsweise wird der sogenannte MUC-Controller (Multi Utility Communication-Controller) vorteilhaft eingesetzt. Zugangsschutz dieser Zusatzgeräte wird durch eine gesonderte, versiegelbare Abdeckung erreicht. Dennoch sind ggf. am Zusatzgerät vorhandene Kundenschnittstellen trotz der versiegelbaren Abdeckung erreichbar.

Davon ausgehend ist es die Aufgabe der Erfindung, Zusatzgeräte der neuen Bauform in Verbindung mit konventionellen Elektrizitätszählern mit Dreipunktbefestigung und Klemmendeckel nutzbar zu machen und deren Installation zu vereinfachen.

Diese Aufgabe wird gelöst durch den Klemmendeckel mit den Merkmalen des Anspruchs 1. Vorteilhafte Ausgestaltungen sind in den sich anschließenden Unteransprüchen angegeben.

Der erfindungsgemäße Klemmendeckel dient zur Abdeckung von Anschlussklemmen eines Elektrizitätszählers, wobei der Klemmendeckel zur Befestigung eines Zusatzgeräts an dem Klemmendeckel vorbereitet ist und eine Kabeldurchführung aufweist, durch die Verbindungskabel zur Verbindung des Zusatzgeräts mit Anschlussklemmen des Elektrizitätszählers hindurchführbar sind, wobei die Kabeldurchführung in an einem Elektrizitätszähler befindlichen Zustand des Klemmendeckels im Bereich der Anschlussklemmen angeordnet ist, sodass die Anschlussklemmen zur Verbindung mit den Verbindungskabeln durch die Kabeldurchführung zugänglich sind, ohne den Klemmendeckel von dem Elektrizitätszähler zu entfernen.

Der Elektrizitätszähler kann insbesondere ein Wechselstromzähler gemäß DIN 43857 Teil 1 oder ein Drehstromzähler gemäß DIN 43857 Teil 2 sein und die in den genannten Vorschriften angegebenen Abmessungen einhalten. Der Klemmendeckel ist so geformt, dass er in der üblichen Weise unterhalb der so ausgebildeten Elektrizitätszähler befestigt werden kann. "Unterhalb" bezieht sich ebenso wie alle weiteren relativen Orts- und Richtungsangaben auf den üblichen Montagezustand eines Elektrizitätszählers und eines zugehörigen Klemmendeckels und gegebenenfalls auf einen vor dem Elektrizitätszähler stehenden Betrachter. Die Befestigung des Klemmendeckels kann durch Plombierschrauben oder vergleichbare Sicherungselemente versiegelt werden. Der Klemmendeckel befindet sich dann in einer definierten Anordnung an dem Elektrizitätszähler. In dieser definierten Anordnung befindet sich bei der Erfindung die Kabeldurchführung im Klemmendeckel im Bereich der Anschlussklemmen des Elektrizitätszählers, sodass die Verbindungskabel für ein Zusatzgerät an den Anschlussklemmen des Elektrizitätszählers angebracht werden können, ohne den Klemmendeckel aus der definierten Position am Elektrizitätszähler zu entfernen.

Das Zusatzgerät kann ein beliebiges elektrisches oder elektronisches Gerät sein, das für die zu von ihm zu erfüllende Funktion mit dem Elektrizitätszähler zu verbinden ist, insbesondere ein Rundsteuergerät, eine Zeitschaltuhr, ein Datenlogger, ein Modem oder ein vergleichbares Gerät oder eine Kombination aus derartigen Geräten.

Die Anschlussklemmen umfassen Anschlüsse für die Phasen des Dreh- bzw. Wechselstroms, einen Nullleiter und ggfs. weitere Anschlussklemmen für die Zusatzgeräte, beispielsweise zum Austausch von Daten mit dem Elektrizitätszähler. Die für die Verbindung mit dem Zusatzgerät vorgesehenen Anschlussklemmen können insbesondere Schraubklemmen, aber auch sonstige Klemmen oder Stecker bzw. Buchsen sein.

Der Klemmendeckel kann insbesondere gemäß der DIN 43860 Teil 2 ausgebildet sein. Der erfindungsgemäße Klemmendeckel erleichtert das Nachrüsten konventioneller Elektrizitätszähler mit einem modernen Zusatzgerät. Dies kommt dem Interesse der Messstellenbetreiber nach verringerter Gerätevielfalt und der Verwendung moderner Zusatzgeräte entgegen.

In einer Ausgestaltung ist die Kabeldurchführung im an einem Elektrizitätszähler befindlichen Zustand des Klemmendeckels vor den Anschlussklemmen angeordnet. "Vor" bedeutet, dass die Kabeldurchführung für einen Betrachter, der vor einem in üblicher Weise montierten Elektrizitätszähler und einem daran angeordneten Klemmendeckel steht, zwischen dem Betrachter und den Anschlussklemmen angeordnet ist. Bei dieser Anordnung ist ein optimaler Zugang zu den Anschlussklemmen gegeben. Die Verbindungskabel können einfach mit den Anschlussklemmen verbunden werden, ohne den Klemmendeckel zu entfernen.

In einer Ausgestaltung weist der Klemmendeckel eine Stirnseite mit zwei Längs- und zwei Schmalseiten auf und die Kabeldurchführung verläuft entlang einer der Längsseiten. Die Stirnseite kann im Wesentlichen rechteckig sein. Die Stirnseite bildet die einem vor dem Elektrizitätszähler mit Klemmendeckel stehenden Betrachter zugewandte Seite. Sie ist zu unterscheiden von den an die Stirnseite angrenzenden seitlichen Flächen des Klemmendeckels, die einen Abstand von der Stirnseite bis zu einer hinteren Wand eines Zählerschranks oder Zählerplatzes überbrücken. Die Stirnseite kann flächig und eben ausgebildet sein. Sie kann jedoch auch in einem unterschiedlichen Abstand von der hinteren Wand des Zählerschranks oder -platzes angeordnet sein und beispielsweise gewölbt oder gewellt sein. Eine der beiden Längsseiten der Stirnseite befindet sich unten, die andere Längsseite ist nahe der Unterseite des Elektrizitätszählers angeordnet. Die beiden Schmalseiten der Stirnseite befinden sich an der rechten und linken Seite des Klemmendeckels. Die Kabeldurchführung kann insbesondere eine langgestreckte Rechteck- oder Trapezform aufweisen, deren Längsrichtung parallel zur Längsseite der Stirnseite verläuft. Die Kabeldurchführung kann unmittelbar an die obere Längsseite angrenzen oder in einem geringen Abstand davon angeordnet sein. Diese Anordnung der Kabeldurchführung stellt ebenfalls einen einfachen Zugang zu den Anschlussklemmen sicher, wenn Elektrizitätszähler und Klemmendeckel in ihrer vorgesehenen Montageposition sind.

In einer Ausgestaltung ist die Kabeldurchführung eine von einer Oberseite des Klemmendeckels ausgehende Ausnehmung in der Stirnseite des Klemmendeckels. Im Gegensatz zu einer Kabeldurchführung in Form einer allseitig umrandeten Öffnung, durch die Verbindungskabel hindurch geführt werden müssen, können die Verbindungskabel für das Zusatzgerät einfach durch die Ausnehmung geführt werden, in dem der Klemmendeckel nach Befestigung der Verbindungskabel am Elektrizitätszähler in seine Montageposition gebracht wird, wobei die Verbindungskabel zwischen dem Elektrizitätszähler und der Klemmendeckel angeordnet sind.

In einer Ausgestaltung ist die Kabeldurchführung des Klemmendeckels in einem Lieferzustand des Klemmendeckels von einem einfach zu entfernenden Materialstück verschlossen. Klemmendeckel und Materialstück können insbesondere aus Kunststoff bestehen. Das Materialstück hat eine der Kabeldurchführung entsprechende Form, beispielsweise rechteckig oder trapezförmig. Damit das Materialstück einfach zu entfernen ist, kann es über eine Schwächungszone mit verringerter Materialstärke mit dem Klemmendeckel verbunden sein. Ebenfalls möglich ist eine Verbindung des Materialstücks mit dem Klemmendeckel über einzelne Stege. Das Materialstück kann dann einfach herausgebrochen werden. Der besondere Vorteil dieser Ausgestaltungen ist, dass der Klemmendeckel mit verschlossener Kabeldurchführung auch unabhängig von einem Zusatzgerät mit einem herkömmlichen Elektrizitätszähler kombiniert werden kann. Er ist dann für die nachträgliche Montage eines Zusatzgeräts vorbereitet.

Gemäß einer Ausgestaltung ist das Materialstück ein in die Kabeldurchführung eingesetzter Rast- oder Schiebedeckel, der von einem Verriegelungsmechanismus in der Kabeldurchführung gehalten ist, wobei das Materialstück nur unter Zerstörung des Verriegelungsmechanismus entfernbar ist. Mit in die Kabeldurchführung eingesetztem Rast- oder Schiebedeckel kann der Klemmendeckel auch unabhängig von einem Zusatzgerät zur sicheren Abdeckung der Anschlussklemmen eines Elektrizitätszählers eingesetzt werden. Um nachträglich ein Zusatzgerät einzusetzen, kann die Kabeldurchführung durch Öffnen des Rast- oder Schiebedeckels einfach geöffnet werden. Eine Manipulation an den Anschlussklemmen ist jedoch ausgeschlossen, weil der Verriegelungsmechanismus beim Öffnen des versiegelten Klemmendeckels von außen zerstört wird, sodass ein Entfernen des Rast- oder Schiebedeckels erkennbar wird.

Gemäß einer Ausgestaltung ist zur Befestigung des Zusatzgeräts an dem Klemmendeckel eine Hutschiene an einer Stirnseite des Klemmendeckels angeordnet. Die Hutschiene kann beispielsweise über zwei Schrauben, die in Bohrungen des Klemmendeckels angeordnet sind, an dem Klemmendeckel befestigt sein. Die Hutschiene kann genormte Abmessungen aufweisen, um ein einfaches Befestigen des Zusatzgeräts an der Hutschiene zu ermöglichen.

In einer Ausgestaltung ist eine Abdeckung vorhanden, die die Kabeldurchführung und teilweise die Verbindungsleitungen zum Zusatzgerät abdeckt. Die Abdeckung kann auch einen Teil des Zusatzgeräts abdecken, wobei ggfs. an dem Zusatzgerät ausgebildete Anzeige- und/oder Bedienelemente sowie Kundenschnittstellen frei zugänglich bleiben. Grundsätzlich kann die Abdeckung aus mehreren Teilen bestehen, beispielsweise aus einem ersten Teil, das die Kabeldurchführung abdeckt, und einem zweiten Teil, das einen Teil der durch die Kabeldurchführung hindurchgeführten Verbindungsleitungen zum Zusatzgerät und wahlweise einen Teil des Zusatzgeräts abdeckt. Die beiden Teile der Abdeckung können so angeordnet sein, dass ein Entfernen eines ersten Teils der Abdeckung nur nach Entfernen eines zweiten Teils der Abdeckung möglich ist. Zur Sicherung der gesamten Abdeckung genügt dann eine Sicherung des zweiten Teils der Abdeckung, insbesondere durch eine Verplombung. Die Abdeckung kann auch einteilig ausgeführt sein, sodass ebenfalls lediglich ein einziges Teil vor unbefugter Entfernung gesichert werden muss.

Bevorzugt ist die Abdeckung nach Befestigung des Zusatzgeräts montiert und versiegelt. Die Versiegelung kann beispielsweise durch eine Plombe oder eine vergleichbare Sicherung erfolgen. Dadurch sind sowohl das Zusatzgerät als auch dessen Verbindungsleitungen und die Anschlussklemmen des Elektrizitätszählers vor unbefugtem Zugriff und unbeabsichtigter Berührung geschützt.

Die obige Aufgabe wird ebenfalls gelöst durch einen Elektrizitätszähler mit Anschlussklemmen und einem Klemmendeckel nach einem der Ansprüche 1 bis 9. Der Elektrizitätszähler kann insbesondere nach DIN 43857 Teil 1 bzw. Teil 2 ausgestaltet sein. Im Übrigen wird auf die vorstehenden Erläuterungen verwiesen, die auch für die erfindungsgemäße Kombination eines Elektrizitätszählers mit einem oben beschriebenen Klemmendeckel Gültigkeit haben.

Die obige Aufgabe wird ebenfalls gelöst durch das Verfahren mit den Merkmalen des Anspruchs 11. Vorteilhafte Ausgestaltungen des Verfahrens sind in den sich anschießenden Unteransprüchen angegeben.

Das Verfahren dient zur Ausrüstung eines Elektrizitätszählers mit einem Zusatzgerät, wobei der Elektrizitätszähler Anschlussklemmen aufweist, die von einem nahe dem Elektrizitätszähler montierten Klemmendeckel abgedeckt sind. Das Verfahren hat die folgenden Schritte:
- Öffnen einer Kabeldurchführung im Klemmendeckel, die im Bereich der Anschlussklemmen des Elektrizitätszählers angeordnet ist,
- Hindurchführen von Verbindungsleitungen zur Verbindung des Zusatzgeräts mit dem Elektrizitätszähler durch die Kabeldurchführung,
- Anschließen der Verbindungsleitungen an die Anschlussklemmen und
- Befestigen des Zusatzgeräts an dem Klemmendeckel, wobei der Klemmendeckel während des gesamten Verfahrens nicht demontiert wird.

Mit dem erfindungsgemäßen Verfahren kann ein herkömmlicher Elektrizitätszähler mit Anschlussklemmen, insbesondere mit Dreipunktbefestigung, einfach mit einem Zusatzgerät ausgerüstet werden. Das Verfahren eignet sich insbesondere zur Nachrüstung eines bereits mit einem Klemmendeckel installierten Elektrizitätszählers. Der Klemmendeckel kann insbesondere bereits verplombt sein oder auf sonstige Weise versiegelt sein. Erfindungsgemäß ist es dann nicht erforderlich, den Klemmendeckel zur Montage des Zusatzgeräts zu entfernen.

Hinsichtlich der Einzelheiten des Verfahrens wird auf die vorstehenden Erläuterungen des erfindungsgemäßen Klemmendeckels und der erfindungsgemäßen Kombination aus Elektrizitätszähler und Klemmendeckel verwiesen.

Gemäß einer Ausgestaltung des Verfahrens erfolgt das Befestigen des Zusatzgeräts durch Aufsetzen des Zusatzgeräts auf eine Hutschiene.

In einer Ausgestaltung wird nach dem Befestigen des Zusatzgeräts eine Abdeckung montiert, die die Abdeckung und/oder mindestens einen Teil des Zusatzgeräts abdeckt.

In einer bevorzugten Ausgestaltung ist der für das Verfahren verwendete Klemmendeckel nach einem der Ansprüche 1 bis 9 ausgestaltet.

Die Erfindung wird nachfolgend anhand eines in vier Figuren dargestellten Ausführungsbeispiels näher erläutert. Es zeigen:
- Fig. 1: einen elektronischen Elektrizitätszähler mit einem erfindungsgemäßen Klemmendeckel in einer perspektivischen Ansicht,
- Fig. 2: die Anordnung aus Figur 1 mit einer an dem Klemmendeckel befestigten Hutschiene,
- Fig. 3: die Anordnung aus Figur 2 mit einem an der Hutschiene befestigten Zusatzgerät, und
- Fig. 4: die Anordnung aus Figur 3 mit einer Abdeckung.

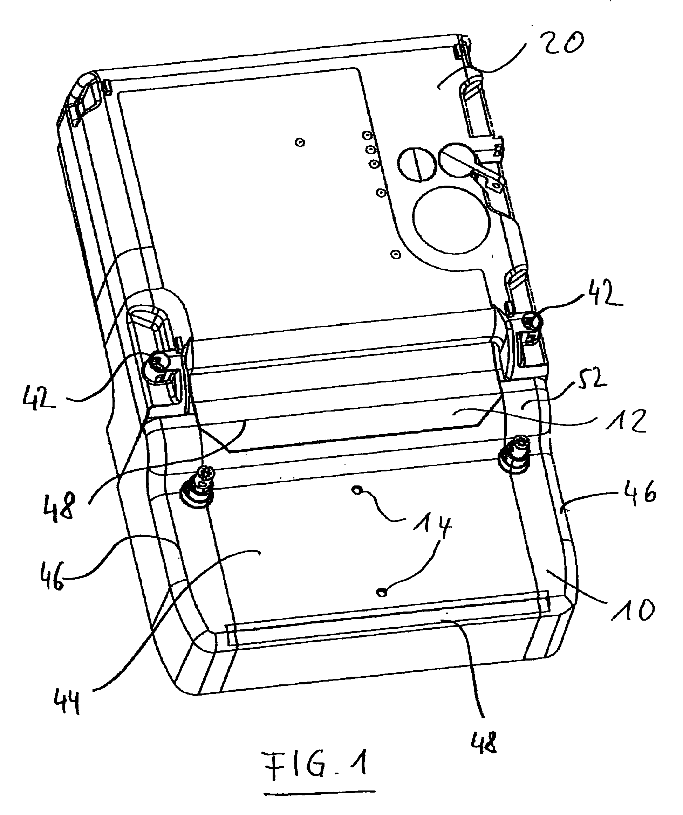

Figur 1 zeigt einen elektronischen Elektrizitätszähler 20, der drei Befestigungspunkte aufweist, über die er mit einem Zählerschrank bzw. einer sonstigen Grundfläche am Zählerplatz befestigt ist. In der gezeigten perspektivischen Ansicht sind zwei Plombierschrauben 42 zur Sicherung des Elektrizitätszählers 20 sichtbar.

Unterhalb des Elektrizitätszählers 20 befindet sich ein Klemmendeckel 10, der am Elektrizitätszähler 20 angeordnet ist. Er hat eine im Wesentlichen quaderförmige Gestalt mit einer Stirnseite 44, die zwei Schmalseiten 46 und zwei Längsseiten 48 aufweist. Die Stirnseite 44 hat einen flächigen, unteren Teil, der parallel zu der Wandung eines Schaltschranks, in dem der Klemmendeckel 10 befestigt ist, verläuft, und einen sich oberhalb an den flächigen Abschnitt anschließenden, nach vom gewölbten Bereich 52. Im Bereich der oberen Längsseite 48 befindet sich eine Kabeldurchführung, die in dem in der Figur 1 gezeigten Lieferzustand des Klemmendeckels 10 noch von einem herausbrechbaren Materialstück 12 verschlossen ist. Etwa in der Mitte der Stirnseite 44 befinden sich zwei Befestigungsbohrungen 14, durch die der Klemmendeckel 10 zur Befestigung eines Zusatzgeräts vorbereitet ist.

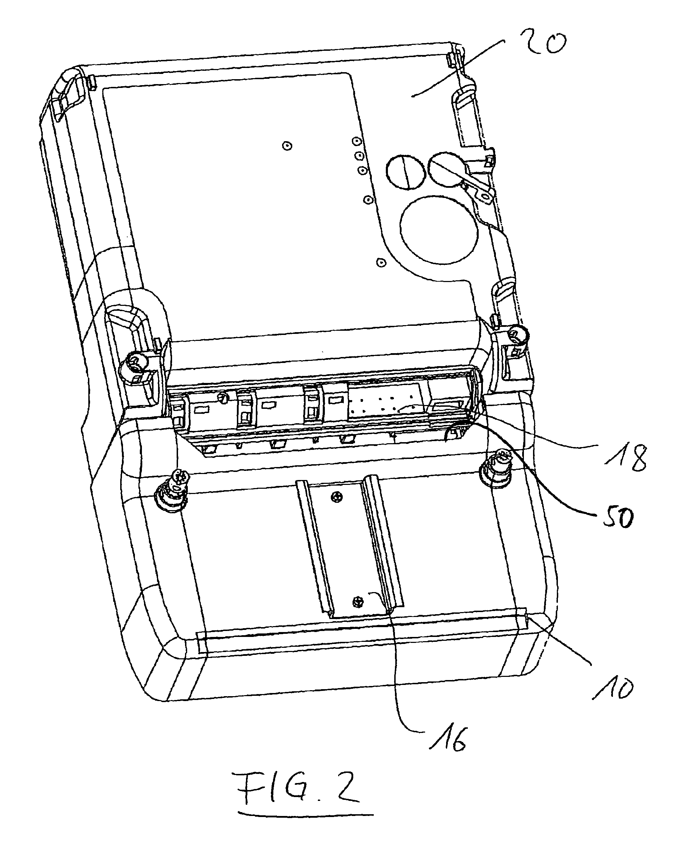

In der Figur 2 ist das herausbrechbare Materialstück 12 entfernt worden, sodass die Kabeldurchführung 50 freien Zugang zu den darunter befindlichen Anschlussklemmen 18 des Elektrizitätszählers 20 bietet. Die Kabeldurchführung 50 hat eine Längsrichtung, die entlang der oberen Schmalseite 48 des Klemmendeckels 10 verläuft. Die Kabeldurchführung 50 ist im Wesentlichen rechteckig, wobei die beiden unteren Ecken abgeschrägt sind, sodass die untere Hälfte der Kabeldurchführung 50 im Wesentlichen trapezförmig ist.

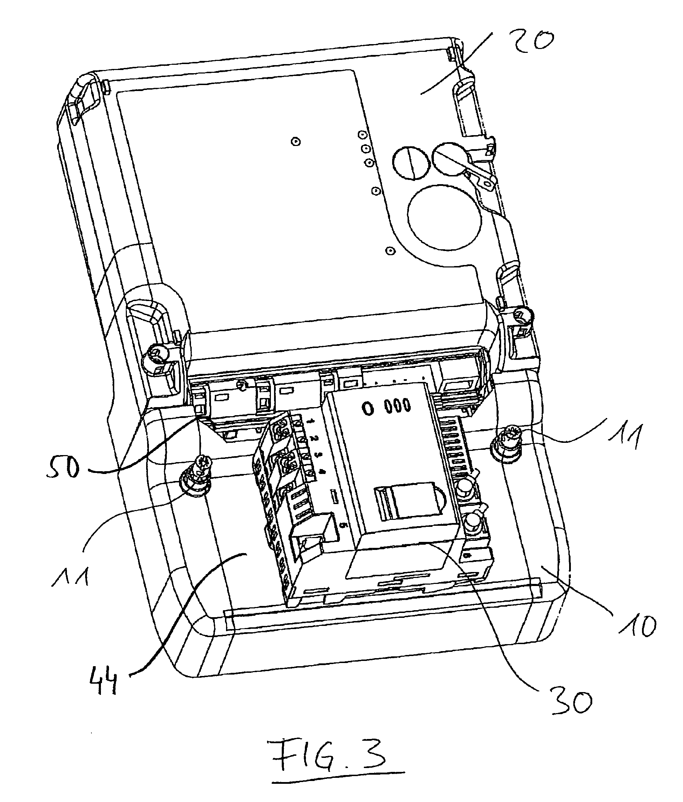

In Figur 3 sind zwei Plombierschrauben 11 erkennbar, mit denen der Klemmendeckel 10 am Elektrizitätszähler befestigt ist. Weiterhin erkennbar ist ein Zusatzgerät 30, das an der Hutschiene 16 auf der Stirnseite 44 des Klemmendeckels 10 befestigt ist. Das Zusatzgerät 30 ist über nicht dargestellte Verbindungsleitungen mit den Anschlussklemmen 18 des Elektrizitätszählers 20 verbunden.

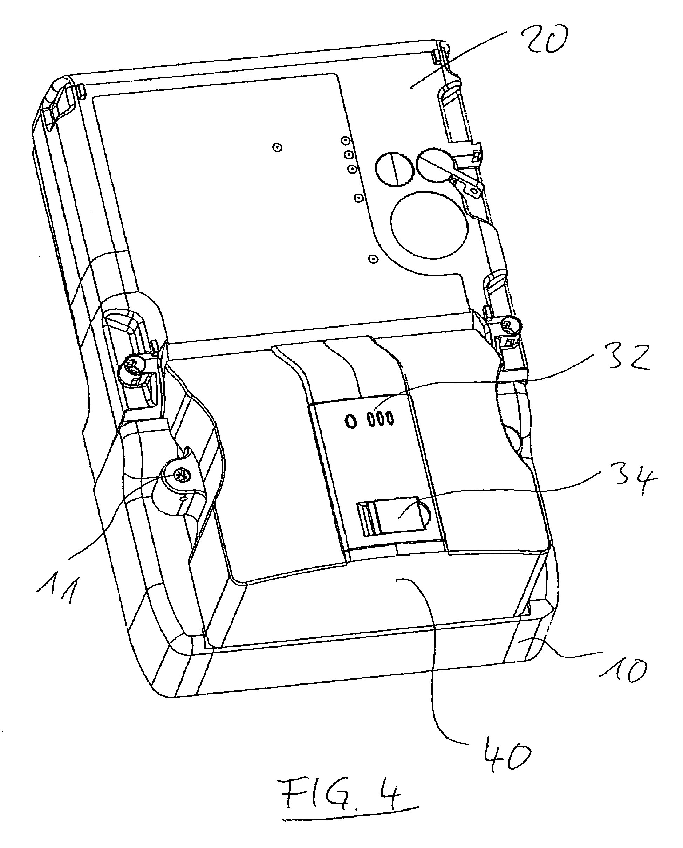

In der Figur 4 ist zusätzlich eine einteilige Abdeckung 40 montiert, die die Kabeldurchführung 50, die Verbindungsleitungen zwischen dem Elektrizitätszähler und dem Zusatzgerät 30 und einen Teil des Zusatzgeräts 30 selbst abdeckt. Anzeigelemente 32 und eine Kundenschnittstelle 34 des Zusatzgeräts 30 bleiben frei zugänglich.

## Patentansprüche

1. Klemmendeckel (10) zur Abdeckung von Anschlussklemmen eines Elektrizitätszählers, wobei der Klemmendeckel (10) zur Befestigung eines Zusatzgeräts (30) an dem Klemmendeckel (10) vorbereitet ist und eine Kabeldurchführung (50) aufweist, durch die Verbindungskabel zur Verbindung des Zusatzgeräts (30) mit Anschlussklemmen des Elektrizitätszähler (20) hindurchführbar sind, **dadurch gekennzeichnet, dass** die Kabeldurchführung (50) im an einem Elektrizitätszähler (20) befindlichen Zustand des Klemmendeckels (10) im Bereich der Anschlussklemmen angeordnet ist, so dass die Anschlussklemmen zur Verbindung mit den Verbindungskabeln durch die Kabeldurchführung (50) zugänglich sind, ohne den Klemmendeckel (10) von dem Elektrizitätszähler (20) zu entfernen.

2. Klemmendeckel (10) nach Anspruch 1, **dadurch gekennzeichnet, dass** die Kabeldurchführung (50) im an einem Elektrizitätszähler (20) befindlichen Zustand des Klemmendeckels (10) vor den Anschlussklemmen angeordnet ist.

3. Klemmendeckel (10) nach Anspruch 1 oder 2, **dadurch gekennzeichnet, dass** der Klemmendeckel (10) eine Stirnseite (44) mit zwei Längs- und zwei Schmalseiten (48, 46) aufweist und die Kabeldurchführung (50) entlang einer der Längsseiten (48) verläuft.

4. Klemmendeckel (10) nach einem der Ansprüche 1 bis 3, **dadurch gekennzeichnet, dass** die Kabeldurchführung (50) eine von einer Oberseite des Klemmendeckels (10) ausgehende Ausnehmung in der Stirnseite (44) ist.

5. Klemmendeckel (10) nach einem der Ansprüche 1 bis 4, **dadurch gekennzeichnet, dass** die Kabeldurchführung (50) in einem Lieferzustand des Klemmendeckels (10) von einem einfach zu entfernendem Materialstück (12) verschlossen ist.

6. Klemmendeckel (10) nach Anspruch 5, **dadurch gekennzeichnet, dass** das Materialstück (12) ein in die Kabeldurchführung (50) eingesetzter Rast- oder Schiebedeckel ist, der von einem Verriegelungsmechanismus in der Kabeldurchführung (50) gehalten ist, wobei der Rast- oder Schiebedeckel von außen nur unter Zerstörung des Verriegelungsmechanismus entfernbar ist.

7. Klemmendeckel (10) nach einem der Ansprüche 1 bis 6, **dadurch gekennzeichnet, dass** zur Befestigung des Zusatzgeräts (30) an dem Klemmendeckel (10) eine Hutschiene (16) an einer Stirnseite (44) des Klemmendeckels (10) befestigt ist.

8. Klemmendeckel (10) nach einem der Ansprüche 1 bis 7, **dadurch gekennzeichnet, dass** eine Abdeckung (40) vorhanden ist, die die Kabeldurchführung (50) und teilweise die Verbindungsleitungen zum Zusatzgerät (30) abdeckt.

9. Klemmendeckel (10) nach Anspruch 8, **dadurch gekennzeichnet, dass** die Abdeckung (40) nach Befestigung des Zusatzgeräts (10) montiert und versiegelt ist.

10. Elektrizitätszähler (20) mit Anschlussklemmen und einem Klemmendeckel (10) nach einem der Ansprüche 1 bis 9.

11. Verfahren zur Ausrüstung eines Elektrizitätszählers (20) mit einem Zusatzgerät (30), wobei der Elektrizitätszähler (20) Anschlussklemmen aufweist, die von einem nahe dem Elektrizitätszähler (20) montierten Klemmendeckel (10) abgedeckt sind, mit den folgenden Schritten:
• Öffnen einer Kabeldurchführung (50) im Klemmendeckel (10), die im Bereich der Anschlussklemmen des Elektrizitätszählers (20) angeordnet ist,
• Hindurchführen von Verbindungsleitungen zur Verbindung des Zusatzgeräts (30) mit dem Elektrizitätszähler (20) durch die Kabeldurchführung,
• Anschließen der Verbindungsleitungen an die Anschlussklemmen und
• Befestigen des Zusatzgeräts (30) an dem Klemmendeckel (10), wobei der Klemmendeckel (10) während des gesamten Verfahrens nicht demontiert wird.

12. Verfahren nach Anspruch 11, **dadurch gekennzeichnet, dass** das Befestigen des Zusatzgeräts (30) durch Aufsetzen des Zusatzgeräts (30) auf eine Hutschiene (16) erfolgt.

13. Verfahren nach Anspruch 11 oder 12, **dadurch gekennzeichnet, dass** nach dem Befestigen des Zusatzgeräts (30) eine Abdeckung (40) montiert wird, die die Kabeldurchführung (50) und/oder mindestens einen Teil des Zusatzgeräts (30) abdeckt.

14. Verfahren nach einem der Ansprüche 11 bis 13, **dadurch gekennzeichnet, dass** der Klemmendeckel (10) nach einem der Ansprüche 1 bis 9 ausgestaltet ist.
